# EUROPEAN PATENT SPECIFICATION

(11) **EP 4 096 357 B1**
(45) Date of publication and mention of the grant of the patent: **18.02.2026**
(21) Application number: 22175999.6
(22) Date of filing: 30.05.2022
(51) Int. Cl.: H05B 6/12, F24C 7/06, F24C 15/10

(54) **ELECTRIC RANGE**
ELEKTROHERD
CUISINIÈRE ÉLECTRIQUE

(30) Priority: 28.05.2021 KR 20210069181
(43) Date of publication of application: 30.11.2022
(73) Proprietor: LG Electronics Inc., SEOUL 07336 (KR)
(72) Inventor: KIM, Seunghak, 08592 Seoul (KR); CHO, Junghyeon, 08592 Seoul (KR)
(74) Representative: Vossius & Partner Patentanwälte Rechtsanwälte mbB

(56) References cited:
- EP-A1- 2 475 220
- DE-A1- 102007 032 762
- GB-A- 1 474 977
- JP-A- H05 251 167
- US-A1- 2007 278 215

## Description

The present disclosure relates to an electric range, more particularly, to an electric range including a single base bracket configured to support and protect a control circuit board, thereby remarkably reducing the number of components in comparison to the conventional electric range, and further including a substrate fastening bolt configured to fasten the control circuit board and the base bracket to the case simultaneously, thereby remarkably reducing the manufacturing cost and manufacturing time.

Various types of cooking utensils or electric appliances are used to heat food at home or in a restaurant. Such cooking electric appliances may include gas range using gas and electric ranges using electricity.

An electric range may be largely classified into a resistance heating type and an induction heating type.

An electrical resistance type may generate heat by applying a current to a non-metallic heating element such as a metal resistance wire and silicon carbide, and may heat an object (e.g., a cooking vessel or container such as a pot or a frying fan) by radiating or conducting the generated heat.

An induction heating type may apply high-frequency power to a coil and generate a magnetic field around the coil, and may heat a heating target made of a metal material by using an eddy current generated in the magnetic field.

In other words, when a current is applied to a working coil or a heating coil, a heating target may be induction-heated to generate heat and the heating object may be heated by the generated heat.

A conventional induction heating type electric range having the above configuration includes a heating portion on which a working coil is wound, a control circuit board configured to supply high-frequency power to the working coil, and a case accommodating the heating portion and the control circuit board.

The case may be provided with means for fixedly supporting the control circuit board and means for connecting and grounding the control circuit board to the case.

In this regard, Korean Patent Laid-Open Publication No. 2014-0124106 (hereinafter, Cited document 001) discloses a configuration of an electric range for supporting a control circuit board by using a support bolt which includes one end fixed to a bottom surface of a case and the other end fixed to the control circuit board.

However, the support bolt disclosed in Cited document 001 has to be provided in plural so as to support the control circuit board at a plurality of positions. Accordingly, when the size of the control circuit board increases, the number of required support bolts must be increased to a significant level, thereby causing a problem in that the number is rapidly increased.

In addition, when using the support bolt, a process of fixing the support bolt to a bottom surface of the case and a control circuit board to the other end of the support bolt so as to fix one end of the support bolt must be provided additionally. Accordingly, there might be a problem in that the manufacturing cost and manufacturing time are rapidly increased.

In addition, the process of fixing one end of the support bolt to the case may proceed from a lower outside of the case. Accordingly, the support bolt must be assembled in a state where the case is turned over or facilitate for assembling the support bolt must be required from the lower outer side of the case, thereby complicating the manufacturing process or requiring additional manufacturing facilities.

US 2007/278215 (A1) relates to an induction heating device and a hob having such an induction heating device.

GB 1 474 977 (A) relates to a cushioned plate assembly comprising a plate of glass ceramic or glass having a low coefficient of heat expansion.

### [Patent Documents]

### Cited Document 001 10-2016-0025170

One object of the present disclosure is to provide an electric range including a single base bracket configured to support and protect a control circuit board, thereby remarkably reducing the number of components in comparison to the conventional electric range.

A further object of the present disclosure is to provide an electric range including a substrate fastening bolt configured to fasten the control circuit board and the base bracket to the case simultaneously, thereby remarkably reducing the manufacturing cost and manufacturing time.

A still further object of the present disclosure is to provide an electric range in which a coupling direction of a substrate fastening bolt configured to secure a control circuit board and a base bracket to the case simultaneously is from the top to the bottom, thereby simplifying a manufacturing process.

Aspects according to the present disclosure are not limited to the above ones, and other aspects and advantages that are not mentioned above can be clearly understood from the following description and can be more clearly understood from the embodiments set forth herein. Additionally, the aspects and advantages in the present disclosure can be realized via means and combinations thereof that are described in the appended claims.

An electric range according to an embodiment of the present disclosure may a cover plate on which a heating target is disposed; a case coupled to a lower surface of the cover plat and having an accommodation space defined therein; a heating portion comprising a working coil to which high-frequency power is applied and configured to heat the heating target by using a magnetic field generated from the working coil; a control circuit board module disposed in the accommodation space and configured to supply high-frequency to the working coil; a base bracket disposed between a bottom surface of the case and the control circuit board module and to which the control circuit board module is secured; and a fastener extended through the control circuit board module and configured to secure the control circuit board module to the base bracket. The fastener may be fastened to the case through the control circuit board module and the base bracket.

The fastener is an electrically conductive fastening bolt.

The fastening bolt may include a head configured to press an upper surface of the control circuit board module; a stem portion protruded from the head; and a male screw portion at least partially formed in an outer circumferential surface of the stem portion. The stem portion may be passes through the control circuit board module and the base bracket and the male screw portion is screw-fastened to the bottom surface of the case.

The male screw portion may enter from an upper surface of the control circuit board module and proceed downward, and may pass through the base bracket to be screw-fastened to the bottom surface of the case.

The case may be formed of a electrically conductive metal plate and an upward forming portion protruding upward may be provided on the bottom surface of the case by a press work. The male-screw portion of the fastening bolt may be screw-fastened through an upper surface of the upward forming portion.

The upper surface of the upward forming portion may be in surface-contact with a lower surface of the base bracket.

A bolt hole through which the male-screw portion of the fastening bolt passes may be formed in the upper surface of the upward forming portion. A burring portion protruding downward may be provided on a lower surface of the bolt hole. The male-screw portion of the fastening bolt may be screw-fastened to the burring portion.

A downward forming portion protruding upward may be provided on the bottom surface of the case by a press work and the upward forming portion may be protruded upward from the downward forming portion.

The area of the downward forming portion may be larger than the area of the base bracket, and the base bracket may be included in the zone of the downward forming portion as a whole.

The base bracket may include a protruded portion protruded toward a lower surface of the control circuit board module, and a lower surface of the protruded portion may be in surface-contact with the upper surface of the upward forming portion.

An upper surface of the protruded portion may be at least partially in surface-contact with the lower surface of the control circuit board module.

A deformable protrusion protruding toward the control circuit board module may be provided on the upper surface of the protruded portion, and the shape of the deformable protrusion may be deformed by the fastening force of the fastening bolt.

The deformable protrusion may be elastically deformable.

The deformable protrusion may be integrally formed with the protruded portion of the base bracket.

The deformable protrusion may be formed separately from the base bracket and attached to the protruded portion of the base bracket. The deformable protrusion may have a higher elastic modulus than the base bracket.

The deformable protrusion may be provided in a ring-shape surrounding the stem portion of the fastening bolt, and an outer diameter of the deformable protrusion may be equal to or larger than an outer diameter of the head of the fastening bolt.

The protruded height of the deformable protrusion may be smaller than the thickness of the protruded portion.

When the fastening bolt is screw-fastened to the bottom surface of the case, the control circuit board module is grounded to the case by the fastening bolt.

The control circuit board module may include a bolt hole through which the stem portion and the male screw portion of the fastening bolt pass through. A ground terminal having a ring-shape may be disposed around the bolt hole of the control circuit board module, and the head of the fastening bolt may be electrically connected to the ground terminal.

An outer diameter of the ring-shaped ground terminal may be equal to or larger than an outer diameter of the head of the fastening bolt.

The present disclosure may have following advantages and effects. The electric range may include the single base bracket configured to support and protect the control circuit board, thereby remarkably reducing the number of components in comparison to the conventional electric range.

In addition, the electric range according to the present disclosure may include the substrate fastening bolt configured to couple the control circuit board and the base bracket to the case simultaneously, thereby remarkably reducing the manufacturing cost and manufacturing time.

In addition, the electric range according to the present disclosure may have a coupling direction of a substrate fastening bolt configured to fasten a control circuit board and a base bracket to the case simultaneously is from the top to the bottom, thereby simplifying a manufacturing process.

Specific effects are described along with the above-described effects in the section of Detailed Description.

### [Description of Reference Numerals]

FIG. 1 is an exploded perspective view of an electric range according to an embodiment of the present disclosure;
FIG. 2 is an exploded perspective view showing the other parts of the electric range shown in FIG. 1, except a cover plate;
FIG. 3 is an exploded perspective view of a heating portion and an upper bracket that are shown in FIG. 2;
FIG. 4 is a perspective view showing an assembled state of a base bracket, a control circuit board module and a ventilation module disposed in a case shown in FIG. 2;
FIG. 5 is a perspective view showing a coupled state a control circuit board module and a ventilation module with respect to a base bracket shown in FIG. 4;

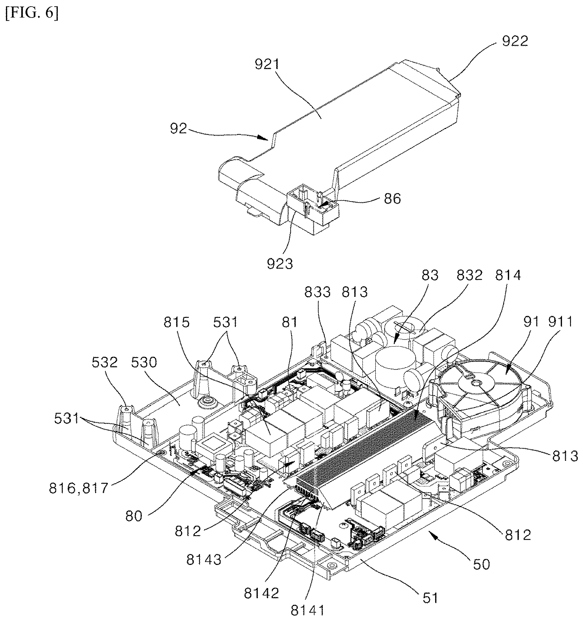

FIG. 6 is an exploded perspective view of an air guide cut away from FIG. 4;
FIG. 7 is a plane view illustrating a assembling state in which a base bracket, a control circuit board module and a ventilation module are assembled inside the case shown in FIG. 2;
FIG. 8 is a partially enlarged view of FIG. 7;
FIG. 9 is a partially enlarged view showing a state where a control circuit board module is omitted in FIG. 8; and
FIGS. 10 and 11 are sectional views cut away along A-A of FIG. 8.

The above-described aspects, features and advantages are specifically described hereunder with reference to the accompanying drawings such that one having ordinary skill in the art to which the present disclosure pertains can easily implement the disclosure. In the disclosure, detailed descriptions of known technologies in relation to the disclosure are omitted if they are deemed to make the understanding of the invention unnecessarily vague. Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

Throughout the disclosure, each element may be singular or plural, unless stated to the contrary.

Hereinafter, expressions of 'a component is provided or disposed in an upper or lower portion' may mean that the component is provided or disposed in contact with an upper surface or a lower surface. The present disclosure is not intended to limit that other elements are provided between the components and on the component or beneath the component.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context. Terms such as "include" or "has" are used herein and should be understood that they are intended to indicate an existence of several components, functions or steps, disclosed in the specification, and it is also understood that greater or fewer components, functions, or steps may likewise be utilized.

Terms such as "include" or "has" are used herein and should be understood that they are intended to indicate an existence of several components, functions or steps, disclosed in the specification, and it is also understood that greater or fewer components, functions, or steps may likewise be utilized.

Throughout the disclosure, the terms "A and/or B" as used herein can denote A, B or A and B, and the terms "C to D" can denote C or greater and D or less, unless stated to the contrary.

Hereinafter, the present disclosure will be described, referring to the accompanying drawings showing a configuration of an electric range 1 according to an embodiment.

### [Overall Composition of Electric Range]

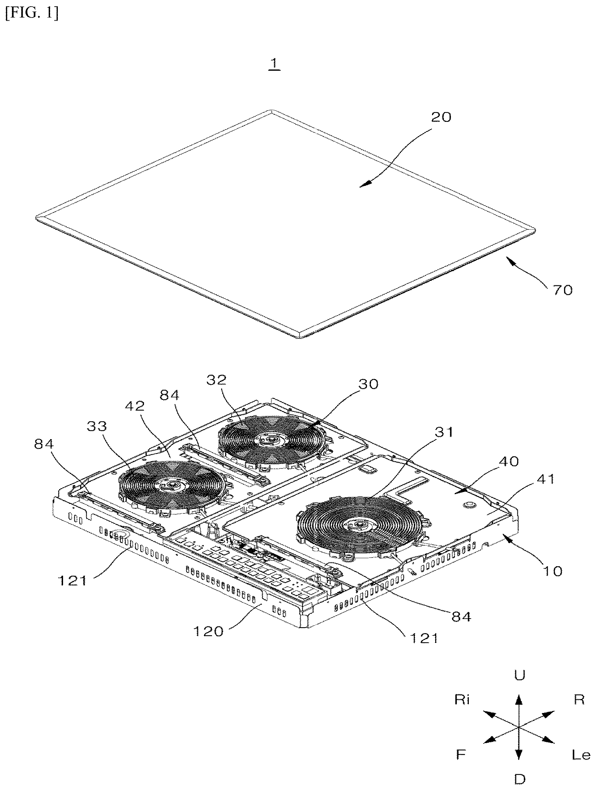

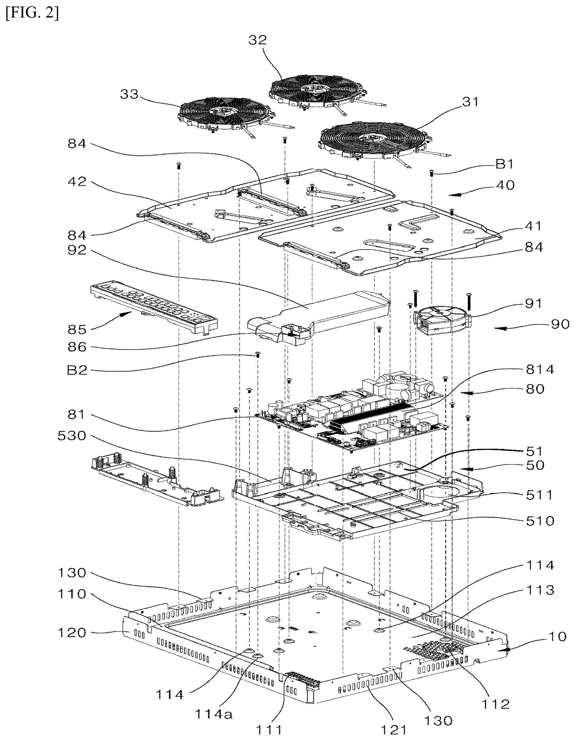

FIG. 1 is an exploded perspective view of an electric range 1 according to an embodiment of the present disclosure, in a state where a cover plate is separated therefrom. FIG. 2 is an exploded perspective view showing the other parts of the electric range shown in FIG. 1, except the cover plate. Referring to FIGS. 1 and 2, the configuration of the electric range 1 according to an embodiment will be described.

The electric range 1 according to this embodiment may be configured to heat a heating target based on an induction heating method. The heating target may be a tableware containing a metal material (e.g., stainless steel and iron).

In the induction heating method, high-frequency power may be applied to a working coil 31 to generate a magnetic field around a working coil 312, 322 and 332, and an eddy current generated by the magnetic field may be used in heating a heating target made of a metal material.

Specifically, high-frequency power may be applied to a heating portion 30 having a structure in which the working coil 31 is disposed adjacent to a ferrite core, so that a magnetic field may be generated around the working coil 31. When a heating target is placed in an area in the generated magnetic field, an eddy current may be induced in the heating object by the magnetic field and Joule's heat may be generated by the eddy current to heat the heating target. As the heating target is heated, the food contained in the heating target may be heated.

The electric range may include a cover plate 20, a heating portion 30, an upper bracket 40 and a base bracket 50.

The case 10 may be configured to define an exterior of the electric range and protect components composing the electric range. As one example, the case 10 may be made of a lightweight metal material such as aluminum and the present disclosure may not be limited thereto.

Meanwhile, the case 10 may be insulated to suppress heat generated by the working coil 31 from being radiated to the outside.

The case 10 may accommodate components constituting the electric range such as the heating portion 30, the upper bracket 40 and a control board module 90. A top of the case 10 may be open and the open top may be closed by the cover plate 20.

The case 10 may be formed in a box shape by processing a plate-shaped material.

The case 10 may include a first casing 110, a second casing 120.

The first casing 110 may define a bottom surface of the case 10. The first casing 110 may accommodate and support the internal components disposed in the above-described electric range in a downward direction (D-direction).

A plurality of forming portions formed by press working may be provided as means for facilitating the accommodation and supporting of the internal components.

A downward forming portion 113 among the plurality of forming portions may be formed by press work to protrude the first casing 110 in a downward direction (D-direction) as a whole. The first casing 110 may be protruded in the downward direction so that a space in a vertical direction (U-direction) may be further secured for the internal components. In addition, the rigidity of the first casing 110 may be further increased.

In this instance, the area of the downward forming portion 113 may be larger than the area of the base bracket 50 so that the base bracket 50 may be disposed to be included in the downward forming portion 113 as a whole.

An upward forming portion 114 may be protruded upward from the downward forming portion 113 (U-direction), and may be formed as a circular bead as shown in the drawing as one example.

The upward forming portion 114 may be formed in a plurality of positions, and may support a lower surface of a base bracket 50 which will be described below to fix the base bracket 50.

To secure the base bracket 50 by using a fastener such as a substrate fastening bolt B2, a bolt hole 114a may be formed in the upward forming portion 114 to secure the base bracket 50 by using at board securing bolt, so that the board securing bolt may penetrate the bolt hole 114a to extend there through. In this instance, the substrate fastening bolt B2 may be extended, passing through the main circuit board 811 and the base bracket 50, so that the main circuit board 811 and the base bracket 50 may be fixed to the first casing 110.

The substrate fastening bolt B2 configured to secure the base bracket 50 may have a securing direction from the top to the bottom (D-direction).

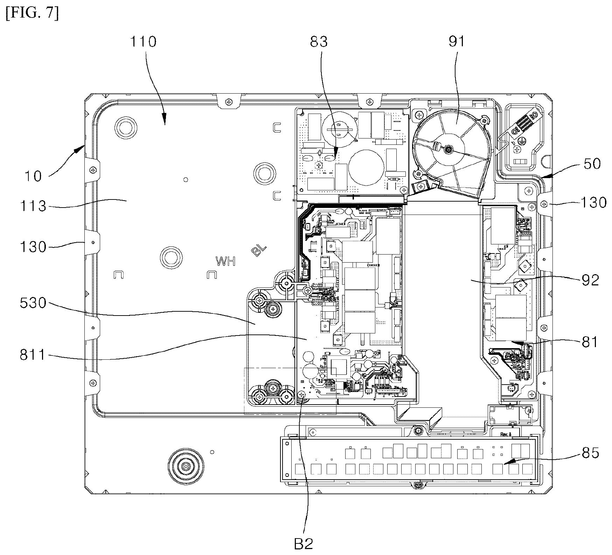

In this instance, since the upward forming portion 114 is protruded from the downward forming portion 113, there may be a margin for preventing the board securing bolt from being extended downward over the first case 110. The securing structure of the base bracket 50 and the main circuit board 811 by using the substrate fastening bolt B2 will be described later, referring to FIG. 7.

Meanwhile, the first casing 110 may include an air inlet hole 112 for drawing air therein and an air outlet hole 111 for discharging air there from, to facilitate the cooling of the control circuit board module 80 provided therein and the circuit elements mounted on the control circuit board module 80.

As shown in FIG. 2, the air outlet hole 111 and the air inlet hole 112 may be provided in the form of a grill, thereby preventing the inflow of foreign substances.

The second casing 120 may be bent from the first casing 110 and configured to define a lateral surface of the case 110.

The second casing 120 may be bent from an edge of the first casing 110 in a vertical direction (U-D direction) to form a side wall of the electric range 1, so that the second casing 120 may be provided to surround the base bracket which will be described later.

The second casing 120 may be formed on each side of the first casing 110 formed in a substantially quadrangular shape. The second casing 120 may reinforce the rigidity of the entire case 10.

Specifically, the second casing 120 bent from the first casing 110 may be configured to suppress the plate-shaped first casing 110 from being bending or damaged by the weight of the internal components or an external force.

The second casing 120 may further include a ventilation hole 121 formed in a slit shape and it may be provided in plurality. The plurality of ventilation holes 121 may facilitate communication between the inside and the outside of the case 100 so that air may flow through the ventilation holes 121, thereby contributing to cooling of the internal components provided in the case 10.

Meanwhile, a supporting flange 130 may be provided in an upper end of the second casing 120.

The supporting flange 130 may be bent from the upper end of the second casing 120 toward the inside of the case 10, and may serve to support the upper bracket 140, which will be described later, from the lower surface. For example, the supporting flange 130 may be formed in a plurality of positions by bending upper ends of a left surface, a right surface and a rear surface of the second casing 110. A securing hole 131 for bolting fastening may be provided in each of the supporting flanges 130.

A bottom surface of the upper bracket 40 may be disposed on an upper surface of the supporting flange 130. The upper bracket 40 and the supporting flange 130 may be coupled to each other by a securing means such as a bracket securing bolt B1. Preferably, a left side end and a rear end of the first upper bracket 41 and a right side end and a rear end of the second upper bracket 42 may be supported and coupled to each other by the supporting flange 130. Here, the right side end of the first upper bracket 41 and the left side end of the second upper bracket 42 may be supported by a supporting bracket 530 which will be described later.

Meanwhile, the cover plate 20 may be coupled to an upper end of the case 10 and a heating target may be placed on the upper surface of the cover plate 20. The cover plate may be configured to close the open top of the case 10 to protect the internal components of the case 10.

The heating target may be put on the upper surface of the cover plate 20 and a magnetic field generated from the heating portion 30 may pass through the cover plate to reach the heating target. For example, the cover plate 20 may be made of a material having excellent heat resistance such as ceramic or tempered glass, but it is not limited thereto.

An input interface (not shown) configured to receive an operation input from the user may be provided on the upper surface of the cover plate 20. The input interface may be disposed on a predetermined area of the upper surface of the cover plate 20 and display a specific image.

The input interface may receive a touch input from the user and the electric range 1 may be operated based on the received touch input.

For example, the input interface may be a module configured to input a desired heating intensity or heating time by a user, and may be implemented as a physical button or a touch panel.

A touch circuit board module 85 configured to receive a user's touch manipulation input may be provided under the input interface, that is, under the cover plate 20. The touch circuit board module 85 may include a plurality of key switches 851 and a touch circuit board 851 on which and the plurality of key switches 851 are mounted. The user can input a command to the touch circuit board module 85 via the key switches 851 to control the operation of the electric range 1.

In the electric range 1 according to an embodiment of the present disclosure, an upper surface of the touch circuit board module 85 may be in close contact with a lower surface of the cover plate 20. At this time, the touch circuit board module 85 may be disposed at a position corresponding to the input interface.

The touch circuit board module 85 and the input interface may be connected to each other by a capacitive touch input method. Accordingly, when the user inputs a control command to the input interface, the control command may be input to the touch circuit board module 85.

In addition, a display may be provided on a predetermined area of the upper surface of the cover plate 20 and configured to display an operation state of the electric range 1.

A light display region may be formed on the upper surface of the cover plate 20. An LED substrate module 84 may be disposed under the cover plate 20, corresponding to the light display region. The light irradiated from the LED substrate module 84 may be transmitted to the user via the light display region. For example, the LED substrate module 84 may be fixedly disposed on an upper bracket 40 which will be described later. The upper bracket 40 may include a plurality of substrate supporting portions 417 and 427 to support the LED substrate module 84.

At this time, the light display region and the LED substrate module 85 may be disposed in positions corresponding to each other. When a plurality of LED substrate modules 84 are provided, the same number of light display regions may be disposed on the upper surface of the cover plate 20.

Meanwhile, the electric range 1 according to one embodiment of the present disclosure may further include a cover bracket 70 configured to support the cover plate 20 and connect the cover plate 20 to the case 10.

As shown in FIG. 1, the cover bracket 70 may be disposed on the outside of the upper bracket 40 and the case, and may be coupled to the case 10, to support the cover plate 20. For example, the cover bracket 70 may be coupled to the case by a securing means such as the case securing bolt (not shown).

A plurality of cover brackets 70 may be provided and each of the cover brackets 70 may be disposed on a position corresponding to each side of the cover plate 20 formed in a quadrangle. As one example, a total of fourth cover brackets 70 may be disposed on respective sides of the rectangular cover plate 20.

Meanwhile, the heating portion 30 may be provided in plural and disposed under the cover plate 20, to heat a heating target.

A total of three heating portions 30 are shown in the accompanying drawings.

The plurality of heating portions 30 may be all provided in the induction heating method, or some of the heating portions 30 may be provided a device using the induction heating method and the other ones thereof may be a highlight heating device using an electric resistance heating method, so that the electric range 1 may be configured as a so-called hybrid range.

Hereinafter, the electric range 1 including the plurality of heating portions 30 all provided in the induction heating method will be described.

In this instance, the plurality of heating portions 30 may be configured to have the same heating capacity or different heating capacities from each other.

The accompanying drawings show an example of the plurality of heating portions including a first heating portion 31, a second heating portion 32 and a third heating portion 33, and the present disclosure may not be limited thereto. The example configured of the first heating portion 31, the second heating portion 32 and the third heating portion 33 that have different heating generation capacities will be described as a standard.

The first heating portion 31 may be secured to the first upper bracket 41. The second heating portion 32 and the third heating portion 33 may be secured to the second upper bracket 42.

The heating portions 31, 32 and 33 may include core frames 311, 322, 332, respectively, in common. The working coils 312, 322 and 332 may be spirally wound around upper surfaces of the core frames 311, 321, 331, respectively, and ferrite cores 313, 323 and 333 may be mounted on lower surface of the core frames 311, 321 and 331, respectively. Accordingly, when high-frequency power is applied to the working coils 312, 322 and 332, a magnetic field may be formed around the ferrite core 313, 323 and 333, and an eddy current may be formed in a heating target by the formed magnetic field.

Each of the working coils 312, 322 and 332 may include a pair of outgoing wires 312a, 322a and 332a, and an outgoing tip terminal may be provided at ends of each lead wire 312a, 322a and 332a.

A temperature sensing portion 60 may be provided in the center of each heating portion 31, 32 and 33. More specifically, a first temperature sensing portion 61 may be provided in the first heating portion 31 and a second temperature sensing portion 62 may be provided in the second heating portion 32. A third temperature sensing portion 63 may be provided in the third heating portion 33.

At this time, the first temperature sensing portion 61 may include a first plate temperature sensor 611 configured to sense the temperature of the cover plate 20 directly above the first heating portion 31, a first thermal fuse (not shown) configured to detect whether the temperature of the cover plate 20 increases above a preset threshold temperature, a first coil temperature sensor 612 configured to sense the temperature of the first working coil 312, and a first sensor holder 614 in which the first plate temperature sensor 611 and the third thermal fuse (not shown) are mounted.

Similarly, the second temperature sensing portion 62 and the third temperature sensing portion 63 may have substantially the same configuration as the first temperature sensing portion 61, respectively. The second temperature sensing portion 62 may include a second plate temperature sensor, a second coil temperature sensor, a second thermal fuse 623 and a second sensor holder 624. The third temperature sensing portion 63 may include a third plate temperature sensor 631, a third coil temperature sensor 632, a third thermal fuse 633 and a third sensor holder 634.

The first to third plate sensors may be configured to directly contact the lower surface of the cover plate 20 so as to measure the temperature of the cover plate 20. The sensing surfaces may be disposed to maintain a contact state with the lower surface of the cover plate 20 at all times.

The first to third coil temperature sensors may be disposed on the lower surfaces of the working coils 312, 322 and 332, and may directly contact the working coils 312, 322 and 332 so as to measure the temperature of the working coils 312, 322 and 332. The sensing surfaces may be disposed to maintain a contact state with the working coils 312, 322 and 332 at all times.

The first to third fuses may serve as a kind of a thermostat configured to disconnect an internal circuit when the temperature of the cover plate 20 increases above a preset threshold temperature. When internal circuits of the first to third thermal fuses are cut off, the power supplied to the working coils 312, 322 and 332 may be immediately cut off to discontinue the operation of the heating portions 31, 32 and 33 in which overheating occurs.

Meanwhile, those heating portions 31. 32 and 33 may be disposed on and supported by the upper bracket 40. As in an example shown in the drawing, the upper bracket 40 may be provided in plurality. Preferably, the upper bracket 50 may include a first upper bracket 41 supporting the first heating portion 31 and a second upper bracket 42 supporting the second heating portion 32 and the third heating portion 33.

The upper bracket 40 may be made of a lightweight metal material (e.g., aluminum), and the present disclosure may not be limited thereto.

The first upper bracket 41 may include a first upper plate 411 and a second upper plate 412. The first upper plate 411 may define a bottom surface of the first upper bracket 41 and the first heating portion 31 may be mounted on the first upper plate 411.

Likewise, the second upper bracket 42 may include a first upper plate 421 and a second upper plate 422. The first upper plate 421 may define a bottom surface of the second upper bracket 42, and the second heating portion 32 and the third heating portion 33 may be mounted on the first upper plate 421.

The first upper plate 411 of the first upper bracket 41 and the first upper plate 421 of the second upper bracket 42 may completely cover a main circuit board module 83 and a power circuit board module 83 provided under the firs upper plate in the vertical direction (U-D direction).

Due to this structure, the first upper plate 411 of the first upper bracket 411 and the first upper plate 421 of the second upper bracket 42 may serve to shield the electromagnetic field and electromagnetic waves generated from the heating portion 30 from reaching elements mounted on the main circuit board module 81 and the power circuit board module 83.

Specifically, the first upper bracket 41 and the second upper bracket 42 may be configured to improve electromagnetic compatibility (EMC) and electromagnetic interference (EMI) performance of the printed circuit board 51.

The second upper plate 412 of the first upper bracket 41 and the second upper plate 422 of the second upper bracket 422 may be bent from respective first upper plates 411 and 421 in the vertical direction (U-D direction) of the electric range 1.

As shown in the drawing, the second upper plates 412 and 422 may be formed in sides of the first upper plates 411 and 421 formed in a substantially quadrangular shape.

The rigidity of the first upper bracket 41 and the second upper bracket 42 may be reinforced as a whole by the second upper plates 412 and 422. That is, the second upper plates 412 and 422 may suppress the plate-shaped first upper plates 411 and 421 from being bent or damaged by the weight of the internal components including the heating portion 30 or an external force.

Meanwhile, each of the first upper plates 411 and 421 may include the pair of outgoing wires 312a, 322a and 332a mentioned above, and a plurality of insertion holes penetrated by lead wires (not shown) of the temperature sensing portion 60 to be extended. For example, the plurality of insertion holes may include a first insertion hole 414 and 424 through which one of the pair of the outgoing wires 312a and 322a and 332a passes, and a second insertion hole 415 and 425 through which the other one of the outgoing wires passes, and a third insertion hole 416 and 426 through which the lead wire of the temperature sensing portion 60 passes.

The pair of lead wires 312a and 322a and 332a and the lead wire of the temperature sensing portion 60 may pass through the insertion holes and extended in the downward direction (D-direction), thereby electrically connected to the control circuit board module 80.

In addition, the first upper plate 411 and 421 may include a plurality of forming portions protruded in the upward direction (U-direction) or the downward direction (D-direction).

The forming portion protruded in the downward direction (D-direction) may be referred to as an anti-pressing forming portion 411a and 421a. The anti-pressing forming portion may serve to prevent the lead wires 312a, 322a extended outward in a radial direction (r-direction_ from the center of each heating portion 31, 32 and 33 among the pair of lead wires 312a, 322a and 332a from being pressed in the mounting process of the heating portions 31, 32 and 33. Specifically, the anti-pressing forming portion 411a and 421a may serve as a passage for the outgoing wire 312a, 322 and 332a extended outward from the center of the heating portion 31, 32 and 33.

The forming portion protruded in the upward direction (U-direction) may be referred to as a securing forming portion 413. At the same time, it may support the heating portion 31, 32 and 33, and may prevent the securing means such as bolts from being extended in the downward direction (D-direction) after passing through the first upper plate 411 and 421. In other words, the securing forming portion 413 may provide a margin for preventing the securing means (e.g., bolts) from interfering with the control board circuit module 80 disposed in the downward direction (D-direction).

A LED substrate module 84 may be disposed on each of the first upper bracket 41 and the second upper bracket 42. Substrate support portions 417 and 427 for supporting the LED substrate module 84 may be formed in the first upper plate 411 of the first upper bracket 41 and the first upper plate 421 of the second upper bracket 421, respectively. The substrate supporting portions 417 and 427 may be formed by partially cutting-away the first upper plate 411 of the first upper bracket 41 and the first upper plate 421 of the second upper bracket 42.

In the example shown in the drawing, one substrate supporting portion 417 may be provided in the first upper bracket 41 on which the first heating portion 31 is disposed. Two substrate supporting portions 427 may be formed in the first upper bracket 41 on which the second heating portion and the third heating portion are disposed.

A plurality of LEDs may be aligned on the LED substrate module 84. The plurality of LEDs may be luminescent when the heating portion 30 is turned on so that the user may be visually informed of whether the heating portion 30 is in operation or an operation state.

The LED substrate module 84 may change the luminescent shape, color, etc. of the plurality of LEDs to inform the user whether or not the electric range 1 is operating and the operation state.

The base bracket 50 may be disposed under the first upper bracket 41. A main circuit board module 81, a power circuit board module 83 that consists the control circuit board module 80 may be mounted on the base bracket 50. The base bracket 50 may be configured to support the main circuit board module 81, the power circuit board module 83 and the ventilation module 90.

The upward forming portions 114 formed in the first casing 110 may support the lower surface of the base bracket 50 at a plurality of positions.

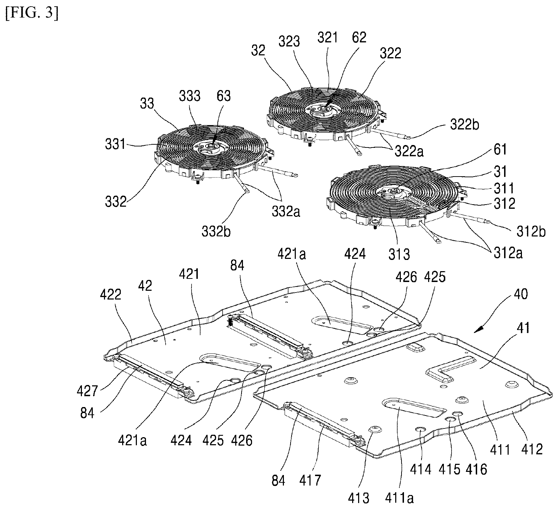

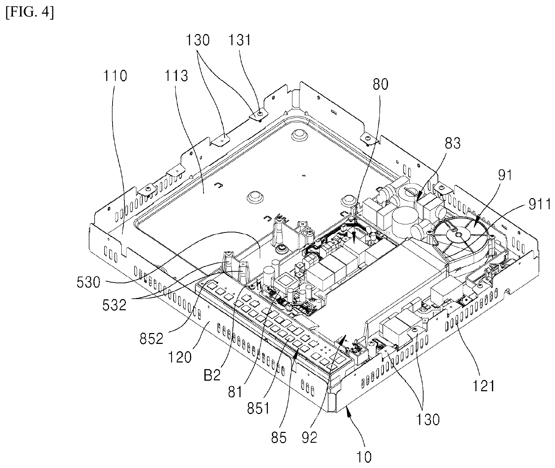

As shown in FIGS. 3 and 4, the base bracket 50 may include a substrate bracket 51 including a bottom plate 510 and a lateral plate 520.

The bottom plate 510 may define a bottom surface of the base bracket 50. The main circuit board module 81, the power circuit board module 83 and the ventilation module 90 may be mounted on an upper surface of the bottom plate 510.

Substrates 811 and 831 provided in the main circuit board module 81 and the power circuit board module 83 may be secured to the bottom plate 510 via a plurality of substrate fastening bolts B2. The substrate fastening bolt B2 may be extended to the upward forming portion 114 of the first casing 110 to be screw-fastened. The substrates 811 and 831 of the main substrate module 81 and the power circuit module 83 and the bottom plate 510 may be secured to the upward forming portion 114 of the first casing 110 by using the substrate fastening bolt B2 at the same time.

Furthermore, any one of the substrate fastening bolts B2 may be configured to act as grounding means for grounding the main circuit board module 81 and the power circuit board module 83. For example, as shown in FG. 4, a copper-foil-shaped ground terminal 817 may be formed around a bolt hole 816 of the main circuit board module 81 through which the board securing bolt is extended, and a head of the substrate fastening bolt may be electrically connected to the ground terminal 817. A stem portion of the board securing bolt may be physically and electrically connected to the upward forming portion 114 of the first casing 110. Through such a simple configuration, the main circuit board module 81 may be effectively grounded to the first casing 110 by the board securing bolt. Although not shown, the same type of a ground terminal (not shown) may be provided in any one of the plurality of bolt holes 833 formed in the power circuit board 831.

Meanwhile, the lateral plate 520 may be extended in the upward direction (U-direction) of the electric range 1 from a lateral surface edge of the bottom plate 510.

The lateral plate 520 may serve to reinforce the rigidity of the entire base bracket 50. That is, the lateral plate 520 may suppress the plate-shaped bottom plate 510 from being bent or damaged by the weight of the internal components (e.g., the circuit board) or the external force. Further, the lateral plate 520 may also serve to protect the main circuit board module 81, the power circuit board module 83 and the ventilation module 90 from the external force applied to the bottom plate 510 in the lateral direction or front-rear direction (F-R direction). For that, the lateral plate 520 may be protruded to a position higher than a position in the vertical direction (U-D direction) of at least the main circuit board 811 and the power circuit board 831.

Meanwhile, a supporting bracket 530 configured to support the first upper bracket 41 and the second upper bracket described above may be provided in a position corresponding to the center of the electric range 1.

The supporting bracket 530 may be provided parallel to the lateral surface of the substrate bracket 51 and the right surface with respect to the drawing. Preferably, the supporting bracket 530 may be integrally formed with the substrate bracket 51. At this time, the supporting bracket 530 may be integrally formed with the substrate bracket 51, but may be configured to be easily decoupled from each other by an external force. For example, a connection portion between the supporting bracket 530 and the substrate bracket 51 may have a relatively weak strength.

The supporting bracket 531 may include a plurality of supporting bosses 531 extended in the upward direction (U-D direction) from a bottom surface a first upper bracket toward the first upper bracket 41 and the second upper bracket 42 described above.

As mentioned above, left and rear ends of the first upper bracket 41 and right and rear ends of the second upper bracket 42 may be supported by and coupled to the supporting flanges 130.

The right end of the first upper bracket 41 and the left end of the second upper bracket 42 may be supported and secured by the supporting bosses 531 of the supporting bracket 530. To couple the right end of the first upper bracket 41 and the left end of the second upper bracket 42 to each other, a coupling hole 532 may be formed in an upper end of each supporting boss 531.

In the example shown in the drawing, a total of five supporting bosses 531 may be provided in the supporting bracket 530. Not all of the five supporting bosses 531 may be used in coupling the right end of the first upper bracket 41 and the left end of the second upper bracket 42. For example, only three supporting bosses 531 out of the five supporting bosses 531 may participate in the coupling between the first upper bracket 41 and the second upper bracket 42.

The other supporting bosses 531 not used in the coupling according to the illustrated example may be used when the supporting bracket 530 supports the first upper bracket 41 and the second upper bracket 42 at a different position in another example. Specifically, when applied to another example of an electric range having a larger size than the electric range described above, the supporting bracket 530 may be decoupled from the substrate bracket 51 and moved to another position to be used. When the supporting bracket 530 is applied to the larger-sized electric range, the other supporting bosses 531 not used in the coupling in this example may be used.

The supporting bracket 530 is configured to be applicable to other examples, thereby facilitating the parts sharing and reducing manufacturing cost.

As described above, the main circuit board module 81 and the power circuit board module 83 that constitute the control circuit board module 80 may be mounted on the base bracket 50. Although not limited thereto, the control circuit board module 80 can be understood as a higher concept including the above-noted LED substrate module 84, the touch circuit board module 85 and the wireless communication substrate module 86 rather than the main circuit board module 81 and the power circuit board module 83.

As shown in FIGS. 3 and 4, the main circuit board module 81 may include a controller configured to the overall operation of the electric range 1, and may be electrically connected to the touch circuit board module 85 and the LED substrate module 84 described above.

Accordingly, the main circuit board module 81 may receive a user' manipulation through the touch circuit board module 85 or a user's manipulation through the wireless communication board module 86 wirelessly or wiredly. The main circuit board module 81 may transmit operational information and status information to the LED substrate module 84 and a user's mobile terminal (not shown).

In addition, on the center of the main circuit board 811 may be mounted a CPU provided as a controller (i.e., a microcontroller, a microcomputer or a microprocessor), a plurality of switching elements 812 configured to convert the power received from the power circuit board module 83 into high-frequency power and supply the converted power to the working coils 312, 322 and 332, and a bridge circuit element 813. The plurality of switching elements 812 may serve as a power converting module.

A plurality of insulated gate bipolar transistors (IGBT) may be applied as the switching elements. However, the IGBT type switching element 812 is a very heat-generating component. If such generated heat is not maintained at an appropriate level, the life span of the switch element 812 will be shortened or a malfunction of the switch element is highly likely to occur.

As a means for cooling the switching element 812, a heat sink 814 configured to absorb heat generated in the plurality of switching elements 812 and the bridge circuit element 813 may be mounted on the main circuit board 811.

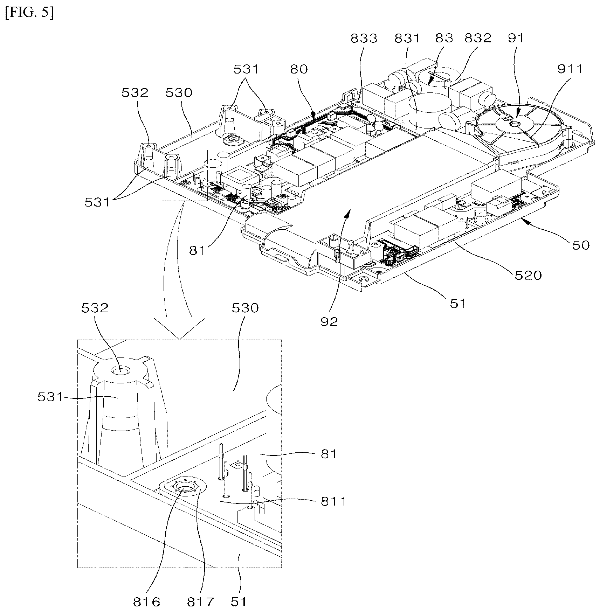

As shown in FIG. 5, the heat sink 814 may include a hexahedral main body 8141 extended along the front-rear direction (F-R direction) of the electric range 1, and a plurality of heat dissipation fins 8143 extended toward the main circuit board 811 from a lower surface of the body 8141.

An upper surface of the main body 8141 may be formed in a plane parallel to the main circuit board 811, and both lateral surfaces of the main body 8141 may be formed as inclined surfaces having a downward inclination.

The switching elements 812 and the bridge circuit element 813 may be attached to the both lateral surfaces having the downward inclination. Accordingly, the heat generated by the switching element 812 and the bridge circuit element 813 may be conducted through both lateral surfaces of the main body 8141.

Meanwhile, a flow channel 8142 may be provided in the main body 8141, and extended in a straight line through front and rear surfaces of the main body 8141. The air may flow along the airflow channel 8142 to a ventilation fan-motor assembly 91 which will be described later. The heat from the switching elements 812 and the bridge circuit element 813 to be conducted may be partially absorbed to the air flow inside the airflow channel 8142.

Meanwhile, concavities and convexities (or unevennesses) may be formed on an inner surface of the airflow channel 8142 and an upper surface of the main body 8141 to expand the contact area for the air flow. The unevenness may be extended in a straight line along the air flow direction, that is, in the front-rear (F-R direction) to minimize the flow resistance.

The plurality of heat dissipation fins 8143 may be protruded from the lower surface of the main body 8141 and extended in the straight line, spaced a constant distance apart from each other. Accordingly, an air passage may be formed between each two neighboring heat dissipation fins adjacent to each other.

Some of the heat dissipation fins, in particular, the ones disposed adjacent to both lateral sides of the lower surface of the main circuit board 811 may directly contact the main circuit board 811. The ones of the heat dissipation fins may serve to support the heat sink 814 as a whole.

In a state where the plurality of switching elements 812 and the bridge circuit element 813 are attached to the heat sink 814, the heat sink 814 may be covered by an air guide 92 which will be described later.

The heat sink 814 may be spatially separated from other circuit elements outside the air guide 92 by the air guide constituting a ventilation module 90, and a cooling passage only for the heat sink may be formed by the air guide 92.

As shown in the drawing, a plurality of filter elements 815 may be disposed in a periphery of the air guide 92 to remove noise included in power output from the power circuit board module 83, which will be described later.

The power circuit board module 83 may be disposed behind the main circuit board module 81. In general, the power circuit board module 83 may be modularized by mounting a high voltage device known as a switching mode power supply (SMPS) on the power circuit board 831. The power circuit board module 83 may convert external power into a stable-stated power before it is supplied to the switching elements 812.

A ventilation fan-motor assembly 91 constituting the ventilation module 90 may be disposed behind the main circuit board module 81, preferably, on the base bracket 50 disposed behind of the heat sink 814.

The ventilation fan-motor assembly 91 may be configured to absorb external air drawn via the air inlet hole 112 of the above-mentioned first casing 110 and the through-hole 511 of the base bracket 50, and blow the air into the air guide 92.

As shown in the drawings, a ventilation fan applied to the ventilation fan-motor assembly 91 may have no limitations, but a sirocco fan may be preferable in consideration of location and spatial restrictions in which the ventilation fan is mounted. When the sirocco fan is applied, external air may be absorbed in from a bottom of the sirocco fan in a direction parallel to a rotation shaft, and the air may be accelerated and discharged radially outward.

To improve air ventilation efficiency, an outlet end 911 of the ventilation fan may be directly connected to an inlet of the air guide 92, and external air forcedly flown by the ventilation fan may be drawn into the air guide as a whole.

The air guide 92 may include a guide body 921 having a U-shaped cross-section and formed in a box shape in which a lower surface is open as a whole.

The heat sink 814 may be mounted in an internal U-shaped space and the cooling passage dedicated to the heat sink 814 may be formed to blow the external air blown through the above-mentioned ventilation fan.

The guide body 921 may be disposed to correspond to the shape in which the heat sink 814 is disposed. When it is extended along the front-rear direction (F-R direction) of the electric range 1 as shown in FIG. 5, the heat sink 815 may be correspondingly arranged in a shape extended along the front-rear direction (F-R direction) of the electric range.

The rear surface of the guide body 921 may be partially open and the open rear surface may serve as an air introduction hole 922 for introducing the external air blown by the ventilation fan.

Unlike the rear surface, a front surface and a lateral surface of the guide body 921 may be completely closed, and may perform a function of a partition wall configured to prevent the introduced external air from leaking to the outside.

The external air introduced into the cooling passage formed in the guide body 921 may flow forward while performing heat-exchange with the heat sink 814, and the flow direction of the external air may be guided by the guide body 921 to finally flow in the downward direction (D-direction), thereby finally being discharged to the outside through the air outlet hole 111 of the first casing 110.

Meanwhile, a substrate mounting portion 923 may be integrally formed with a front surface of the guide body 921, preferably, a front left area of the front surface. The substrate mounting portion 923 may be protruded from the front left area in the upward direction.

The substrate mounting portion 923 may accommodate the above-mentioned wireless communication substrate module 86. The position of the substrate mounting portion 923 may be determined as a position which can minimize the influence of high-frequency noise generated by the heating portion 30 and the switching elements 812. The position that is the most distant from the heating portion 30 and the switching elements 812 may be selected.

[Securing and supporting structure of Main circuit board module and Power circuit board module]

Hereinafter, referring to FIGS. 7 to 11, the securing and supporting structure of the main circuit board module 81 and the power circuit board module 83 according to an embodiment will be described.

As described above, the main circuit board module 81, the power circuit board module 83 may be mounted and supported to the substrate bracket 51 of the base bracket 50. Also, described above, the ventilation module 90 may be mounted behind the circuit board module 81 together.

As described above, the base bracket 50 may include the substrate bracket 51 and the supporting bracket 530, and may be integrally formed with them by injection molding. Compared with the conventional support structure using the plurality of supporting bolts as in the prior art, the structure for supporting the main circuit board 811 and the power circuit board module 83 may be integrally manufactured. Accordingly, the number of the components provided in the electric range 1 according to the embodiment of the present disclosure can be reduced remarkably.

As shown in FIG. 7, when the main circuit board module 81 and the power circuit board module 83 are separately disposed, the board bracket 51 may have an area for disposing the main circuit board module 81 and another area for disposing the power circuit board module 83.

In addition, when they are separately disposed, the main circuit board module 81 and the power circuit board module 83 may be separately secured to the substrate bracket 51 of the base bracket 50 by using fasteners (e.g., the substrate fastening bolt B2).

For the securing using the substrate coupling bolt B2, a plurality of bolt holes 816 and 833 may be provided in the main circuit board 811 of the main circuit board module 81 and the power circuit board 831 of the power circuit board module 83 to pass the substrate coupling bolt B2 there through.

The bolt holes 816 and 833 may be formed at positions which causes no inference with various substrate elements mounted on the main circuit board 811 and the power circuit board 831 in the assembly process. As one example, the bolt holes 816 through which the substrate coupling bolts B2 pass the main circuit board 811 may formed in four corners of the main circuit board 811.

Screw bolts having the same shape and size as each other may be applied as the substrate coupling bolt B2 for securing the main circuit board 811 and coupling the power circuit board 831. Alternatively, screw bolts having the well-known standard in the art may be applied as the substrate coupling bolts B2. Through this, the manufacturing cost required for coupling the main circuit board 811 and the power circuit board 831 may be reduced.

As will be described, the main circuit board module 81 and the power circuit board module 83 may be grounded by the substrate coupling bolt B2. The substrate coupling bolt B2 may be a screw bolt having conductivity.

A ground terminal 817 for the grounding through the substrate coupling bolt B2 may be formed in any one of the bolt holes 816 formed in the circuit board 811, and any one of the bolt holes 833 formed in the power circuit board 831.

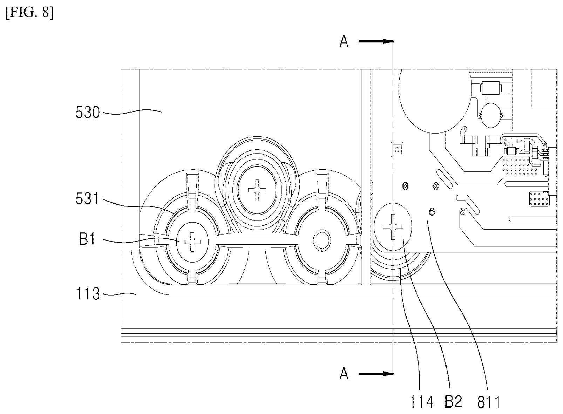

At this time, the ground terminal 817 may be formed at a position to avoid high-frequency noise generated from the substrate elements mounted on the main circuit board 811 and the power circuit board 831. As shown in FIG. 8, the main circuit board 811 may be disposed adjacent to the bolt hole 816 formed in a front right corner as a top surface of the main circuit board 811. Similarly, the ground terminal 817 provided on the power circuit board 831 may be formed at a position to avoid high-frequency noise generated from the substrate elements.

Hereinafter, an exemplary embodiment will be described as reference in which the ground terminal 817 is disposed adjacent to the bolt hole 816 formed in the front right corner as the top surface of the main circuit board 811.

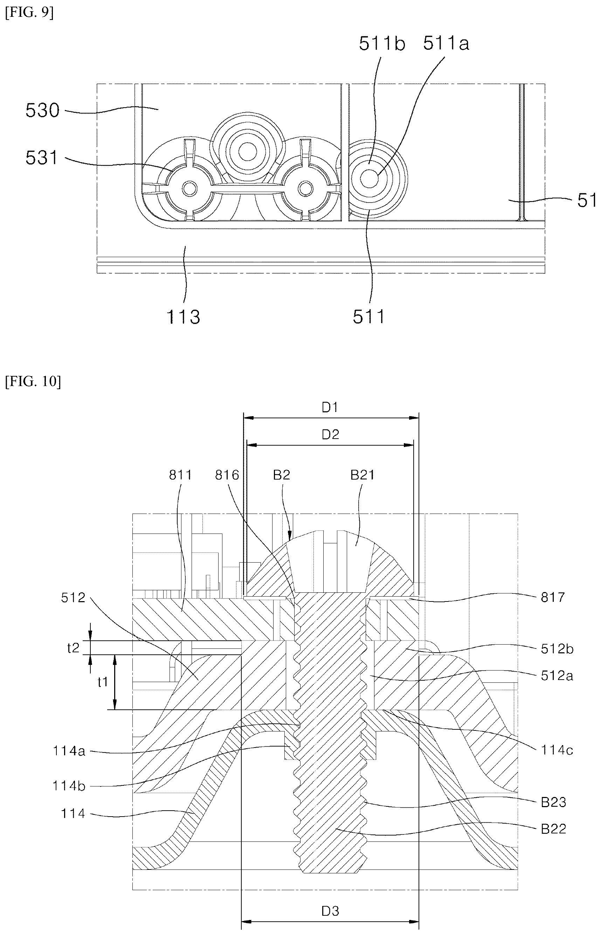

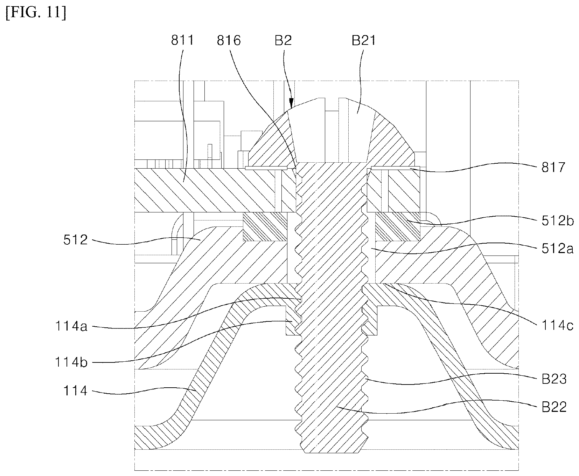

The ground terminal 817 may be made of a ring-shaped copper foil surrounding the bolt hole 816, and may electrically contact the head B21 of the substrate coupling bolt B2 in the assembling process of the substrate coupling bolt B2 configured to secure the main circuit board 811 which will be described later. The configuration related to the electric contact between the head B21 and the ground terminal 817 will be described later, referring to FIGS. 10 and 11. Meanwhile, the configuration of the ground terminal 817 is already well-known in the art to which the present disclosure pertains, and detailed description thereof is omitted accordingly.

Meanwhile, the substrate fastening bolts B2 having passed through the bolt holes 816 and 833 of the main circuit board 811 may penetrate the substrate bracket 51 of the base bracket 50 and then the first casing 110.

Specifically, after penetrating the base bracket 50, the substrate fastening bolt B2 for securing the main circuit board 811 and the power circuit board 831 may be coupled to the first casing 110 functioning as the bottom surface of case 10. Accordingly, the substrate fastening bolt B2 of the electric range 1 according to one embodiment of the present disclosure may serve as the function of securing the circuit board 811 and the function of securing the base bracket 50.

The substrate fastening bolt B2 may enter from the upper surfaces of the main circuit board 811 and the power circuit board 831 and proceed in the downward direction (D-direction), to pass through the substrate bracket 51 of the base bracket 50 and be screw-fastened to the first casing 110. In other words, the fastening of the substrate fastening bolt B2 may be configured to have a direction from the top to the bottom. The downward fastening direction may be equally applied to the above-described bracket securing bolt B1, and may be equally applied to screw bolts applied as other securing means. Through this configuration, an auxiliary assembly means for turning over the product or downward coupling in the assembly process can be excluded, so that the electric range 1 according to the present disclosure can have an effect of simplifying the manufacturing process and remarkably reducing the manufacturing time.

A protruded portion 512 of the base bracket 50 and the upward forming portion 114 of the first casing 110 may be disposed under the bolt hole 816 of the main circuit board 811 and the bolt hole 833 of the power circuit board 831.

FIGS. 9 and 10 show an embodiment in that the protruded portion 512 of the base bracket 50 and the upward forming portion 114 of the first casing 110 are provided under the bolt hole 816 of the main circuit board 811. Hereinafter, the embodiment will be described as reference of the supporting and securing structure of the main circuit board 811 and detailed description thereof will be omitted. Unless otherwise described, the same structure may be applied to the power circuit board 831.

As shown in FIGS. 9 and 10, a protruded portion 512 may be provided in the substrate bracket 51 of the base bracket 50, and the protruded portion 512 may be protruded toward the lower surface of the main circuit board 811.

The protruded portion 512 may be provided in a truncated cone shape protruded from the lower surface of the substrate bracket 51, and a flat surface may be provided on a top of the protruded portion 512. The upper surface of the protruded portion 512 may directly support the lower surface of the main circuit board 811, and the flat surface may expand the contact area to stably support the main circuit board 811.

As described above, the plurality of substrate elements may be mounted on the main circuit board 811. Lead terminals (not shown) of the substrate elements may be protruded downward toward the substrate bracket 51 from the lower surface of the main circuit board 811.

The protruded portion 512 may facilitate a preset distance spaced apart between the substrate bracket 51 and the main circuit board 811 to prevent the lead terminals of the substrate elements from contacting the substrate bracket 51. Such the protruded portion 512 may be formed at a plurality of positions to support the inside of the main circuit board 811 as well as a position through which the substrate fastening bolt B2 passes, as shown in the drawings.

Meanwhile, as shown in FIG. 10, a deformable protrusion 512b may be provided on the upper surface of the protruded portion 512 through which the substrate fastening bolt B2 passes, and the deformable protrusion 512b may be protruded toward the lower surface of the main circuit board 811. As one example, the deformable protrusion 512b may be formed around the bolt hole 512a and have a ring shape surrounding a stem portion B22 of the substrate fastening bolt B2.

As described above, the main circuit board 811 and the base bracket 50 may be fastened to the first casing 110 by using the substrate fastening bolt B2, and may be grounded with the main circuit board 811 simultaneously.

FIG. 10 shows that a lower surface of the head B21 of the substrate fastening bolt B2 may contact the ground terminal 817 formed around the bolt hole 816 of the main circuit board 811 to be grounded with the first casing 110 formed of a electrically conductive metal plate material. As shown in the drawing, an outer diameter D1 of the ground terminal 817 formed in the ring shape may be equal to or greater than an outer diameter D2 of the head B21, thereby maintaining the grounded state between the ground terminal 817 and the head B21 effectively.

As will described later, a stem portion B22 and a male-screw portion of the substrate fastening bolt B2 may pass through the bolt hole 114a of the first casing 110. The fastening may proceed in such a way that the male screw portion B23 is screw-fastened to the burring portion 114b of the first casing 110. As time passes after the fastening is completed, there is a high possibility that the loosening of the screw connection occurs due to external factors such as vibration. Due to this, the electrical connection between the head B21 of the substrate fastening bolt B2 and the ground terminal 817 is highly likely to become unstable.

The deformable protrusion 512b provided in on the upper surface of the protruded portion 512 provided in the substrate bracket 51 may be configured to generate a preload for preventing the loosening of the screw-fastening.

Specifically, when the screw fastening proceeds between the male screw portion B23 of the substrate fastening bolt B2 and the burring portion 114b of the first casing 110, the height of the deformable protrusion 512b may be gradually reduced by the pressing force of the head B21 and deformation may proceed.

At this time, as shown in FIG. 10, since it is integrally formed with the protruded portion 512 of the substrate bracket 51, the deformable protrusion 512b may have the same material as the base bracket 50 made by plastic injection molding, thereby having a predetermined elasticity due to plastic characteristics

Accordingly, the deformable protrusion 512b may be elastically deformed by the pressing force of the head B21. After the fastening of the substrate fastening bolt B2 is completed, the deformable protrusion 512b may function as a kind of a washer configured to generate a preload for preventing the loosening of the screw fastening.

Meanwhile, the protruded height t2 of the deformable protrusion 512b from the upper surface of the protruded portion 512 may be smaller than the thickness t1 of the protruded portion 512. Preferably, the protrusion height t2 may be set to have a level of almost no height, when the deformation is completed by the pressing force of the head B21 of the substrate fastening bolt B2. Once the deformation is completed, the contact area between the lower surface of the main circuit board 811 and the upper surface of the protruded portion 512 may increase and the preload of the deformable protrusion 512b may act.

An outer diameter D3 of the deformable protrusion 512b may be equal to or larger than an outer diameter D2 of the head B21 of the substrate fastening bolt B2, so that the pressure applied to the head B21 may be transmitted to the deformable protrusion 512b as a whole.

As another example, FIG. 11 shows that the deformable protrusion 512b is separately formed to be attached to the upper surface of the protruded portion 512.

The deformable 512b may be provided separately from the substrate bracket 51 and, may be formed of a material different from that of the substrate bracket 51. Preferably, the deformable protrusion 512b may be formed of a material having a higher elastic modulus than the substrate bracket 51.

When the deformable protrusion 512b is made of the material having a higher elastic modulus and deformed by the pressing force of the head B21 of the substrate fastening bolt B2, a larger restoring force may act to loosen the substrate fastening bolt B2 and a larger preload for preventing the loosening of the substrate fastening bolt B2 may be applied.

Meanwhile, the upward forming portion 114 may be disposed under the protruded portion 512 of the substrate bracket 51. As described above, the upward forming portion 114 may be pressed to be protruded upward (U-direction) from the downward forming portion 113. Preferably, the upward forming portion may be formed in a bead shape having a substantially circular cross section and the shape may correspond to that of the lower surface of the protruded portion 512 of the substrate bracket 51.

An upper surface 114c of the upward forming portion 114 may include a partially flat surface. The flat surface of the upward forming portion 114 may be in surface-contact with the lower surface of the protruded portion 512 of the substrate bracket 51. In other words, the structure in that the upward forming portion 114 may support the substrate bracket 51 in a surface-contact state may be achieved by the flat surface.

In addition, a bolt hole 114a through which the stem portion B22 and the male screw portion B23 of the substrate fastening bolt B2 are extended may be provided on the upper surface 114c of the upward forming portion 114. A burring portion 114b may be protruded from a lower surface of the bolt hole 114a downward (D-direction).

The male screw portion B23 of the substrate fastening bolt B2 may be directly screw-fastened to the burring portion 114b. Preferably, the burring portion 114b may be integrally formed with the upward forming portion 114.

Through this, without adding auxiliary members such as nuts, the male screw portion B23 of the substrate fastening bolt B2 may be fastened to the upward forming portion 114 smoothly.

The embodiments are described above with reference to a number of illustrative embodiments thereof. However, the present disclosure is not intended to limit the embodiments and drawings set forth herein, and numerous other modifications and embodiments can be devised by one skilled in the art. Further, the effects and predictable effects based on the configurations in the disclosure are to be included within the range of the disclosure, which is defined by the claims, though not explicitly described in the description of the embodiments.

## Claims

1. An electric range comprising:
a cover plate (20) on which a heating target can be disposed;
a case (10) coupled to the cover plate (20) and having an accommodation space defined therein;
a heating portion (30) comprising a working coil to which high-frequency power is applied and configured to heat the heating target by using a magnetic field generated from the working coil;
a control circuit board module (80) disposed in the accommodation space and configured to supply high-frequency to the working coil;
a base bracket (50) disposed between a bottom surface of the case (10) and the control circuit board module (80) and to which the control circuit board module (80) is coupled; and
a fastener extended through the control circuit board module (80) and configured to fasten the control circuit board module (80) to the base bracket (50),
**characterized in that**
the fastener is fastened to the case (10) through the control circuit board module (80) and the base bracket (50),
wherein the fastener is a fastening bolt (B2), and
wherein when the fastening bolt (B2) is screw-fastened to the bottom surface of the case (10), the control circuit board module (80) is grounded to the case (10) by the fastening bolt (B2).

2. The electric range of claim 1, wherein the fastening bolt (B2) comprises,
a head (B21) configured to press an upper surface of the control circuit board module (80);
a stem portion (B22) protruded from the head (B21); and
a male screw portion (B23) at least partially formed in an outer circumferential surface of the stem portion (B22), and
wherein the stem portion (B22) passes through the control circuit board module (80) and the base bracket (50) and the male screw portion (B23) is screw-fastened to the bottom surface of the case (10).

3. The electric range of claim 2, wherein the male screw portion (B23) is configured to enter from an upper surface of the control circuit board module (80) and proceed downward, and pass through the base bracket (50) to be screw-fastened to the bottom surface of the case (10).

4. The electric range of claim 3, wherein the case (10) is formed of an electrically conductive metal plate,
an upward forming portion (114) protruding upward is provided on the bottom surface of the case (100), and
the male-screw portion (B23) of the fastening bolt (B2) is screw-fastened through an upper surface of the upward forming portion (114).

5. The electric range of claim 4, wherein the upper surface of the upward forming portion (114) is in surface-contact with a lower surface of the base bracket (50).

6. The electric range of claim 4 or 5, wherein a bolt hole (114a) through which the male-screw portion of the fastening bolt (B2) passes is formed in the upper surface of the upward forming portion (114),
a burring portion (114b) protruding downward is provided on a lower surface of the bolt hole (114a), and
the male-screw portion of the fastening bolt (B2) is screw-fastened to the burring portion (114b).

7. The electric range of any one of claims 4 to 6, wherein a downward forming portion (113) protruding upward is provided on the bottom surface of the case (10), and
the upward forming portion (114) is protruded upward from the downward forming portion (113).

8. The electric range of claim 7, wherein an area of the downward forming portion (113) is larger than an area of the base bracket (50), and
the base bracket (50) is included in a region of the downward forming portion (113) as a whole.

9. The electric range of any one of claims 4 to 8, wherein the base bracket (50) comprises a protruded portion (512) protruding toward a lower surface of the control circuit board module (80), and
a lower surface of the protruded portion (512) is in surface-contact with the upper surface of the upward forming portion (114).

10. The electric range of claim 9, wherein an upper surface of the protruded portion (512) is at least partially in surface-contact with the lower surface of the control circuit board module (80).

11. The electric range of claim 10, wherein a deformable protrusion (512b) protruding toward the control circuit board module (80) is provided on the upper surface of the protruded portion (512), and the shape of the deformable protrusion (512b) is deformed by the fastening force of the fastening bolt (B2).

12. The electric range of claim 11, wherein the deformable protrusion (512b) is formed separately from the base bracket (50) and attached to the protruded portion (512b) of the base bracket (50), and
the deformable protrusion (512b) has a higher elastic modulus than the base bracket (50).

13. The electric range of claim 11 or 12, wherein the deformable protrusion (512b) is provided in a ring-shape surrounding the stem portion (B22) of the fastening bolt (B2), and
an outer diameter of the deformable protrusion (512b) is equal to or larger than an outer diameter of the head (B21) of the fastening bolt (B2).

14. The electric range of any one of claims 1 to 13, wherein the control circuit board module (80) comprises:
a bolt hole (816) through which the stem portion (B22) and the male screw portion (B23) of the fastening bolt (B2) pass through,
a ground terminal (817) having a ring-shape, and disposed around the bolt hole (816) of the control circuit board module (80), and
wherein the head (B21) of the fastening bolt (B2) is electrically connected to the ground terminal (817),
wherein, preferably, an outer diameter of the ring-shaped ground terminal (817) is equal to or larger than an outer diameter of the head (B21) of the fastening bolt (B2).

## Patentansprüche

1. Elektrischer Herd, umfassend:
eine Abdeckplatte (20), auf der ein Heizobjekt angeordnet werden kann;
ein Gehäuse (10), das mit der Abdeckplatte (20) gekoppelt ist und in seinem Inneren einen Aufnahmeraum definiert;
einen Heizteil (30), der eine Arbeitsspule umfasst, auf die eine Hochfrequenzleistung aufgebracht wird, und der dazu ausgelegt ist, das Heizobjekt mittels eines von der Arbeitsspule erzeugten Magnetfeldes zu erhitzen;
ein Steuer-Leiterplattenmodul (80), das im Aufnahmeraum angeordnet ist und dazu ausgelegt ist, der Arbeitsspule eine Hochfrequenz bereitzustellen;
einen Basisträger (50), der zwischen einer Unterseite des Gehäuses (10) und dem Steuer-Leiterplattenmodul (80) angeordnet ist und an den das Steuer-Leiterplattenmodul (80) gekoppelt ist; und
ein Befestigungselement, das sich durch das Steuer-Leiterplattenmodul (80) erstreckt und dazu ausgelegt ist, das Steuer-Leiterplattenmodul (80) am Basisträger (50) zu befestigen,
**dadurch gekennzeichnet, dass**
das Befestigungselement über das Steuer-Leiterplattenmodul (80) und den Basisträger (50) am Gehäuse (10) befestigt ist,
wobei das Befestigungselement ein Befestigungsbolzen (B2) ist, und
wobei, wenn der Befestigungsbolzen (B2) an der Unterseite des Gehäuses (10) verschraubt ist, das Steuer-Leiterplattenmodul (80) durch den Befestigungsbolzen (B2) am Gehäuse (10) gehalten wird.

2. Elektrischer Herd nach Anspruch 1, wobei der Befestigungsbolzen (B2) umfasst:
einen Kopf (B21), der dazu ausgelegt ist, eine Oberseite des Steuer-Leiterplattenmoduls (80) zu drücken;
einen Schaftabschnitt (B22), der vom Kopf (B21) hervorsteht; und
einen Außengewindeabschnitt (B23), der zumindest teilweise an einer äußeren Umfangsfläche des Schaftabschnitts (B22) ausgebildet ist, und
wobei der Schaftabschnitt (B22) das Steuer-Leiterplattenmodul (80) und den Basisträger (50) durchdringt und der Außengewindeabschnitt (B23) an der Unterseite des Gehäuses (10) verschraubt ist.

3. Elektrischer Herd nach Anspruch 2, wobei der Außengewindeabschnitt (B23) dazu ausgelegt ist, von einer Oberseite des Steuer-Leiterplattenmoduls (80) aus einzudringen, sich nach unten fortzusetzen und den Basisträger (50) zu durchdringen, um an der Unterseite des Gehäuses (10) verschraubt zu werden.

4. Elektrischer Herd nach Anspruch 3, wobei das Gehäuse (10) aus einer elektrisch leitfähigen Metallplatte gebildet ist,
eine nach oben gerichtete Umformung (114), die sich nach oben erstreckt, an der Unterseite des Gehäuses (10) angeordnet ist, und
der Außengewindeabschnitt (B23) des Befestigungsbolzens (B2) über eine Oberseite der nach oben gerichteten Umformung (114) verschraubt ist.

5. Elektrischer Herd nach Anspruch 4, wobei die Oberseite der nach oben gerichteten Umformung (114) flächig mit einer Unterseite des Basisträgers (50) in Kontakt steht.

6. Elektrischer Herd nach Anspruch 4 oder 5, wobei
in der Oberseite der nach oben gerichteten Umformung (114) ein Bolzenloch (114a) ausgebildet ist, durch das der Außengewindeabschnitt des Befestigungsbolzens (B2) hindurchtritt,
an einer Unterseite des Bolzenlochs (114a) ein nach unten vorspringender Entgratungsabschnitt (114b) angeordnet ist, und
der Außengewindeabschnitt des Befestigungsbolzens (B2) mit dem Entgratungsabschnitt (114b) verschraubt ist.

7. Elektrischer Herd nach einem der Ansprüche 4 bis 6, wobei an der Unterseite des Gehäuses (10) eine nach unten gerichtete Umformung (113) angeordnet ist, die nach unten hervorsteht, und
die nach oben gerichtete Umformung (114) von der nach unten gerichteten Umformung (113) nach oben hervorsteht.

8. Elektrischer Herd nach Anspruch 7, wobei
eine Fläche der nach unten gerichteten Umformung (113) größer ist als eine Fläche des Basisträgers (50), und
der Basisträger (50) vollständig innerhalb eines Bereichs der nach unten gerichteten Umformung (113) angeordnet ist.

9. Elektrischer Herd nach einem der Ansprüche 4 bis 8, wobei der Basisträger (50) einen Vorsprungsteil (512) umfasst, der in Richtung einer Unterseite des Steuer-Leiterplattenmoduls (80) hervorsteht, und
eine Unterseite des Vorsprungsteils (512) flächig mit der Oberseite der nach oben gerichteten Umformung (114) in Kontakt steht.

10. Elektrischer Herd nach Anspruch 9, wobei eine Oberseite des Vorsprungsteils (512) zumindest teilweise flächig mit der Unterseite des Steuer-Leiterplattenmoduls (80) in Kontakt steht.

11. Elektrischer Herd nach Anspruch 10, wobei an der Oberseite des Vorsprungsteils (512) ein verformbarer Vorsprung (512b) angeordnet ist, der in Richtung des Steuer-Leiterplattenmoduls (80) hervorsteht, und
die Form des verformbaren Vorsprungs (512b) durch die Befestigungskraft des Befestigungsbolzens (B2) verformt wird.

12. Elektrischer Herd nach Anspruch 11, wobei
der verformbare Vorsprung (512b) getrennt vom Basisträger (50) ausgebildet und am Vorsprungsteil (512) des Basisträgers (50) befestigt ist, und
der verformbare Vorsprung (512b) ein Elastizitätsmodul aufweist, das größer ist als das des Basisträgers (50).

13. Elektrischer Herd nach Anspruch 11 oder 12, wobei
der verformbare Vorsprung (512b) in ringförmiger Gestalt angeordnet ist und den Schaftabschnitt (B22) des Befestigungsbolzens (B2) umgibt, und
ein Außendurchmesser des verformbaren Vorsprungs (512b) gleich oder größer ist als ein Außendurchmesser des Kopfes (B21) des Befestigungsbolzens (B2).

14. Elektrischer Herd nach einem der Ansprüche 1 bis 13, wobei das Steuer-Leiterplattenmodul (80) umfasst:
ein Bolzenloch (816), durch das der Schaftabschnitt (B22) und der Außengewindeabschnitt (B23) des Befestigungsbolzens (B2) hindurchtreten,
eine Erdungsklemme (817) mit ringförmiger Gestalt, die um das Bolzenloch (816) des Steuer-Leiterplattenmoduls (80) angeordnet ist,
wobei der Kopf (B21) des Befestigungsbolzens (B2) elektrisch mit der Erdungsklemme (817) verbunden ist,
wobei vorzugsweise ein Außendurchmesser der ringförmigen Erdungsklemme (817) gleich oder größer ist als ein Außendurchmesser des Kopfes (B21) des Befestigungsbolzens (B2).

## Revendications

1. Cuisinière électrique comprenant :
une plaque de couverture (20) sur laquelle une cible de chauffage peut être disposée ;
un boîtier (10) accouplé à la plaque de couverture (20) et présentant un espace de réception défini en son sein ;
une partie de chauffage (30) comprenant une bobine de travail à laquelle une puissance à haute fréquence est appliquée et conçue pour chauffer la cible de chauffage au moyen d'un champ magnétique généré à partir de la bobine de travail ;
un module de carte de circuit imprimé de commande (80) disposé dans l'espace de réception et conçu pour fournir une haute fréquence à la bobine de travail ;
un support de base (50) disposé entre une surface inférieure du boîtier (10) et le module de carte de circuit imprimé de commande (80) et auquel le module de carte de circuit imprimé de commande (80) est accouplé ; et
un élément de fixation s'étendant à travers le module de carte de circuit imprimé de commande (80) et conçu pour fixer le module de carte de circuit imprimé de commande (80) au support de base (50),
**caractérisée en ce que**
l'élément de fixation est fixé au boîtier (10) par l'intermédiaire du module de carte de circuit imprimé de commande (80) et du support de base (50),
dans laquelle l'élément de fixation est un boulon de fixation (B2), et
dans laquelle lorsque le boulon de fixation (B2) est fixé par vis à la surface inférieure du boîtier (10), le module de carte de circuit imprimé de commande (80) est retenu sur le boîtier (10) par le boulon de fixation (B2).

2. Cuisinière électrique selon la revendication 1, dans laquelle le boulon de fixation (B2) comprend,
une tête (B21) conçue pour presser une surface supérieure du module de carte de circuit imprimé de commande (80) ;
une partie tige (B22) faisant saillie à partir de la tête (B21) ; et
une partie vis mâle (B23) au moins partiellement formée dans une surface circonférentielle externe de la partie tige (B22), et
dans laquelle la partie tige (B22) passe à travers le module de carte de circuit imprimé de commande (80) et le support de base (50) et la partie vis mâle (B23) est fixée par vis à la surface inférieure du boîtier (10).

3. Cuisinière électrique selon la revendication 2, dans laquelle la partie vis mâle (B23) est conçue pour entrer à partir d'une surface supérieure du module de carte de circuit imprimé de commande (80) et poursuivre vers le bas, et passer à travers le support de base (50) pour être fixée par vis à la surface inférieure du boîtier (10).

4. Cuisinière électrique selon la revendication 3, dans laquelle le boîtier (10) est formé d'une plaque métallique électriquement conductrice,
une partie de formation vers le haut (114) s'étendant vers le haut est disposée sur la surface inférieure du boîtier (10), et
la partie vis mâle (B23) du boulon de fixation (B2) est fixée par vis par l'intermédiaire d'une surface supérieure de la partie de formation vers le haut (114).

5. Cuisinière électrique selon la revendication 4, dans laquelle la surface supérieure de la partie de formation vers le haut (114) est en contact de surface avec une surface inférieure du support de base (50).

6. Cuisinière électrique selon la revendication 4 ou 5, dans laquelle un trou de boulon (114a) à travers lequel la partie vis mâle du boulon de fixation (B2) passe est formé dans la surface supérieure de la partie de formation vers le haut (114),
une partie d'ébavurage (114b) faisant saillie vers le bas est disposée sur une surface inférieure du trou de boulon (114a), et
la partie vis mâle du boulon de fixation (B2) est fixée par vis à la partie d'ébavurage (114b).

7. Cuisinière électrique selon l'une quelconque des revendications 4 à 6, dans laquelle une partie de formation vers le bas (113) faisant saillie vers le bas est disposée sur la surface inférieure du boîtier (10), et
la partie de formation vers le haut (114) fait saillie vers le haut à partir de la partie de formation vers le bas (113).

8. Cuisinière électrique selon la revendication 7, dans laquelle une zone de la partie de formation vers le bas (113) est plus grande qu'une zone du support de base (50), et
le support de base (50) est inclus dans une région de la partie de formation vers le bas (113) dans son ensemble.

9. Cuisinière électrique selon l'une quelconque des revendications 4 à 8, dans laquelle le support de base (50) comprend une partie en saillie (512) faisant saillie en direction d'une surface inférieure du module de carte de circuit imprimé de commande (80), et
une surface inférieure de la partie en saillie (512) est en contact de surface avec la surface supérieure de la partie de formation vers le haut (114).

10. Cuisinière électrique selon la revendication 9, dans laquelle une surface supérieure de la partie en saillie (512) est au moins partiellement en contact de surface avec la surface inférieure du module de carte de circuit imprimé de commande (80).

11. Cuisinière électrique selon la revendication 10, dans laquelle une saillie déformable (512b) faisant saillie en direction du module de carte de circuit imprimé de commande (80) est disposée sur la surface supérieure de la partie en saillie (512), et
la forme de la saillie déformable (512b) est déformée par la force de fixation du boulon de fixation (B2).

12. Cuisinière électrique selon la revendication 11, dans laquelle la saillie déformable (512b) est formée séparément du support de base (50) et fixée à la partie en saillie (512b) du support de base (50), et
la saillie déformable (512b) présente un module d'élasticité supérieur à celui du support de base (50).

13. Cuisinière électrique selon la revendication 11 ou 12, dans laquelle la saillie déformable (512b) est disposée sous une forme annulaire entourant la partie tige (B22) du boulon de fixation (B2), et
un diamètre externe de la saillie déformable (512b) est égal ou supérieur à un diamètre externe de la tête (B21) du boulon de fixation (B2).

14. Cuisinière électrique selon l'une quelconque des revendications 1 à 13, dans laquelle le module de carte de circuit imprimé de commande (80) comprend :
un trou de boulon (816) à travers lequel la partie tige (B22) et la partie vis mâle (B23) du boulon de fixation (B2) passent,
une borne de terre (817) présentant une forme annulaire, et disposée autour du trou de boulon (816) du module de carte de circuit imprimé de commande (80), et
dans laquelle la tête (B21) du boulon de fixation (B2) est électriquement connectée à la borne de terre (817),
dans laquelle, de préférence, un diamètre externe de la borne de terre annulaire (817) est égal ou supérieur à un diamètre externe de la tête (B21) du boulon de fixation (B2).
